# EUROPEAN PATENT APPLICATION

(11) **EP 1 318 550 A2**
(43) Date of publication of application: **11.06.2003**
(21) Application number: 02026252.3
(22) Date of filing: 26.11.2002
(51) Int. Cl.: H01L 33/00, H04B 10/14

(54) **Semiconductor light-emitting element and optical transmission device**

(30) Priority: 27.11.2001 JP 2001361191
(71) Applicant: Kabushiki Kaisha Toyota Chuo Kenkyusho, Aichi-gun, Aichi-ken, 480-1192 (JP)
(72) Inventor: Kato, Satoru, c/o K. K. Toyota Chuo Kenkyusho, Aichi-gun, Aichi-ken, 480-1192 (JP); Ito, Hiroshi, c/o K. K. Toyota Chuo Kenkyusho, Aichi-gun, Aichi-ken, 480-1192 (JP); Kachi, Tetsu, c/o K. K. Toyota Chuo Kenkyusho, Aichi-gun, Aichi-ken, 480-1192 (JP)
(74) Representative: Schmidtchen, Jürgen Christian

(57) **Abstract**

A semiconductor light-emitting element has a GaN type green LED, and a wavelength selecting element which selects and outputs only predetermined wavelength components. The wavelength selecting element is formed by an interference filter or an etalon, and selects and outputs only wavelength components of 520 nm or less from green light emitted by the GaN type green LED. If it is desired to make a response speed even faster, the wavelength selecting element may select and output only wavelengths at a shorter wavelength side of a central wavelength of an emission spectrum (i.e., wavelengths of 515 nm or less).

## Description

### BACKGROUND OF THE INVENTION

### Field of the Invention

The present invention relates to a semiconductor light-emitting element and an optical transmission device, and in particular, to a semiconductor light-emitting element and optical transmission device which are suited to the carrying out of optical communication by use of a plastic optical fiber (hereinafter, "POF").

### Description of the Related Art

In optical communications over relatively short distances (of up to 100 m), an optical transmission device is used which can transmit and receive light signals via a POF which is an optical transmission medium. The optical transmission device is equipped with a light-emitting element which emits light signals, and a light-receiving element which receives light signals from another optical transmission device.

An AlGaInP type red light-emitting diode, which can respond at a high speed, is used as the light-emitting element. However, AlGaInP type red light-emitting diodes have the problems that, due to changes in temperature, the emission output decreases greatly (e.g., the emission output decreases to about 60% with respect to a change in temperature of 100°C) and the emission wavelength also varies greatly (e.g., the emission wavelength varies by about 20 nm with respect to a change in temperature of 100°C). Thus, there are great variations in the transmission loss at the POF, and the transmission distance is limited to about 50 m.

On the other hand, in recent years, GaN type green light-emitting diodes (wavelength: 520 nm), which emit green light which is in a wavelength region in which the loss of the POF is low, have come onto the market as displays. A GaN type green light-emitting diode can emit green light which is in a wavelength region in which the loss of the POF is low. Moreover, a GaN type green light-emitting diode has the advantages that, as compared with a red light-emitting diode, there is little decrease in the emission output with respect to changes in temperature (e.g., the emission output decreases to about 75% with respect to a change in temperature of 100°C), and there is also little variation in the emission wavelength with respect to changes in temperature (e.g., the emission wavelength varies by about 3.3 nm with respect to a change in temperature of 100°C). Thus, it was thought that, with GaN type green light-emitting diodes, light transmission of 100 m or more was possible. However, there is the problem that the falling characteristic of a GaN type green light-emitting diode is poor.

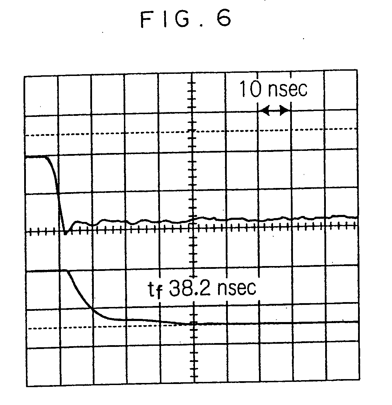

Fig. 6 is a diagram showing the measured waveform at the falling time of a GaN type green light-emitting diode. Here, the upper line which has been drawn is the driving current waveform of a GaN type green light-emitting diode, and the lower line which has been drawn is the emission output waveform. In accordance with Fig. 6, the falling characteristic of the light output during digital operation of the GaN type green light-emitting diode (i.e., the time t_{f} required for the output to change from 90% to 10%) is about 38 nsec. Thus, a GaN type green light-emitting diode can only output light signals to about 20 Mbps, and cannot be used as a device for high-speed optical communication.

### SUMMARY OF THE INVENTION

The present invention has been proposed in order to overcome the above-described drawbacks, and an object of the present invention is to provide a semiconductor light-emitting element and an optical transmission device whose response characteristics are improved by the falling time of a light signal outputted from a GaN type green light-emitting diode being shortened.

The present invention overcomes the above-described drawbacks by utilizing the property that the long-wavelength components of green light emitted by a GaN type green light-emitting diode slow the falling time of the emission output.

Namely, a first aspect of the present invention is a semiconductor light-emitting element comprising: a GaN type green light-emitting diode emitting green light; and a wavelength selecting element selecting and outputting only light of wavelengths at which a falling time of emission output of the GaN type green light-emitting diode is less than or equal to an average value. In this way, because the falling time of the emission output can be shortened, the response characteristic can be improved, and the transmission speed of light signals can be increased.

In the first aspect, it is possible for the wavelength selecting element to select and output only light of wavelengths of 520 nm or less from the green light. Because the wavelength of the green light outputted from the wavelength selecting element becomes 520 nm or less, the falling time can be shortened to 50 nsec or less, and the response speed can be improved.

In the first aspect, it is possible for the wavelength selecting element to select and output only light of wavelengths of less than or equal to a central wavelength of an emission spectrum of the green light. The central wavelength of the emission spectrum of the green light is about 515 nm. The wavelength selecting element selects and outputs light whose wavelength is 515 nm or less from the green light emitted from the GaN type green light-emitting diode. In this way, because the falling time can be shortened to about 40 nsec or less, the response speed can be improved even more.

A second aspect of the present invention is an optical transmission device comprising: a semiconductor light-emitting element having a GaN type green light-emitting diode emitting green light, and a wavelength selecting element selecting and outputting only light of wavelengths at which a falling time of emission output of the GaN type green light-emitting diode is less than or equal to an average value; and an optical fiber transmitting the green light emitted by the semiconductor light-emitting element.

In this way, in the second aspect, optical communication can be carried out by using green light having an improved response speed. Thus, the loss of the light signal at the optical fiber can be suppressed, and decreases in output due to fluctuations in temperature can be reduced. Moreover, long distance transmission, which was impossible with conventional red light-emitting diodes, can be carried out.

A third aspect of the present invention is an optical transmission device comprising: a first GaN type green light-emitting diode emitting green light; a light-receiving element receiving green light from a second GaN type green light-emitting diode which is different from the first GaN type green light-emitting diode; and a wavelength selecting element provided at at least one of a light-emitting surface of the first GaN type green light-emitting diode and a light-receiving surface of the light-receiving element, and selecting and outputting only light of wavelengths at which a falling time of emission output of one of the first and second GaN type green light-emitting diodes is less than or equal to an average value.

In this way, even if no wavelength selecting element is provided at the semiconductor light-emitting element of another optical transmission device, the response characteristic of light signals transmitted from another optical transmission device can be improved.

Note that, in the third aspect, if it is desired to make the response speed even faster, it is possible for the wavelength selecting element to select and output, from the green light, only light of wavelengths of 520 nm or less, or only light of wavelengths less than or equal to the central wavelength of the emission spectrum of the green light.

### BRIEF DESCRIPTION OF THE DRAWINGS

Fig. 1 is a diagram showing a response characteristic when respective wavelengths are separated from the emission wavelength of a GaN type green light-emitting diode (i.e., showing a rising time tᵣ [msec], a falling time t_{f} [msec], and an output amplitude [mV], with respect to respective wavelengths).
Fig. 2 is a diagram showing a structure of an optical transmission device relating to an embodiment of the present invention.
Fig. 3 is a diagram showing a structure of a semiconductor light-emitting element.
Fig. 4 is a diagram showing another structure of the semiconductor light-emitting element.
Fig. 5 is a diagram showing a structure of a GaN type green LED 11.
Fig. 6 is a diagram showing a measured waveform at the falling time of a GaN type green light-emitting diode.

### DESCRIPTION OF THE PREFERRED EMBODIMENTS

Hereinafter, first, the principles of the present invention will be described. Then, preferred embodiments of the present invention will be described in detail with reference to the drawings.

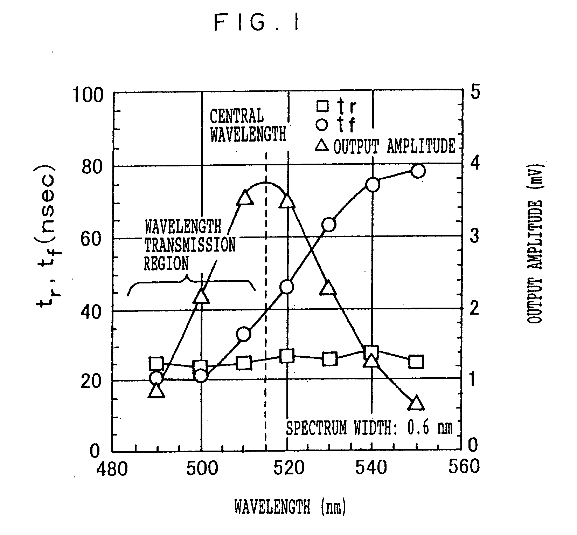

Fig. 1 is a diagram showing the response characteristic (a rising time tᵣ [msec], a falling time t_{f} [msec], and an output amplitude [mV], with respect to respective wavelengths) when respective wavelengths are separated from the emission wavelength of a GaN type green light-emitting diode (hereinafter called "GaN type green LED"). Note that spectra of 0.6 nm were obtained by a spectroscope along the full width at half maximum for the respective wavelengths in the emission spectrum of the GaN type green LED.

The output amplitude values have the same configuration as the emission spectrum of the GaN type green LED. As a result, at the side of wavelengths longer than the central wavelength (515 nm) of the emission spectrum of the GaN type green LED, it was observed that the falling time t_{f} became longer in proportion to the wavelength. This means that the falling characteristic deteriorates due to the light components at the longer wavelength side of the central wavelength of the emission spectrum.

In accordance with Fig. 1, the falling time t_{f} is a minimum of 20 nsec at the short wavelength side, and is a maximum of 80 nsec at the long wavelength side. Here, as one method of making the response speed faster, there is a method of setting the falling time t_{f} to 50 nsec, which is the average of the minimum value and the maximum value thereof. In this case, it suffices to select a wavelength which is 520 nm or less, from the green light emitted by the GaN type green LED. Note that, when the response speed is to be increased, it suffices to selectively output only wavelengths at the shorter wavelength side of the central wavelength of the emission spectrum (i.e., it suffices to selectively output only wavelengths of 515 nm or less).

As described above, if only wavelengths which are at the shorter wavelength side are selected and outputted from the green light of the GaN type green LED, the falling time t_{f} can be shortened, and the response speed can be improved.

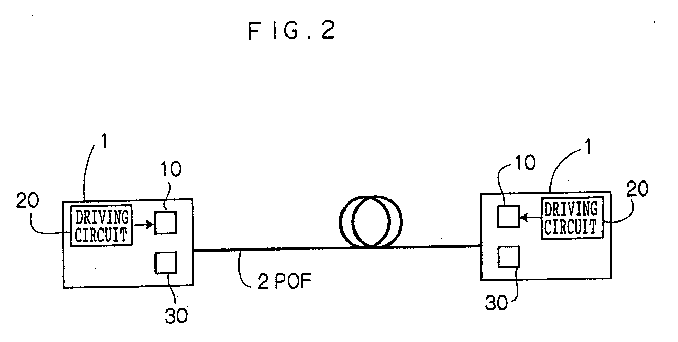

Fig. 2 is a diagram showing the schematic structure of an optical transmission device 1 relating to an embodiment of the present invention. The optical transmission device 1 transmits and receives light signals via a POF 2 which is an optical transmission medium. The optical transmission device 1 includes a semiconductor light-emitting element 10 which emits green light, an LED driving circuit 20 which drives the semiconductor light-emitting element 10, and a light-receiving element 30 which receives green light via the POF 2 from another optical transmission device.

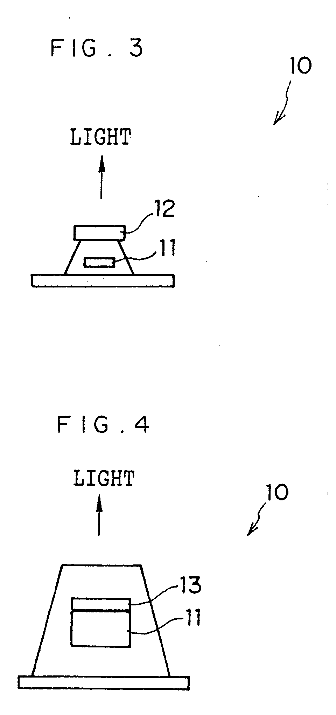

Fig. 3 is a diagram showing the structure of the semiconductor light-emitting element 10. The semiconductor light-emitting element 10 has a GaN type green LED 11 which emits green light, and a wavelength selecting element 12 which selects and outputs only predetermined wavelength components.

As shown in Fig. 1, the GaN type green LED 11 emits green light having output amplitudes [mV] of the same configuration as the emission spectrum. In accordance with Fig. 1, the central wavelength of the green light is about 515 nm.

The wavelength selecting element 12 is formed by an interference filter or an etalon, and selects and outputs only wavelength components of 520 nm or less from the green light from the GaN type green LED 11. In this way, the falling time t_{f} of the green light outputted from the wavelength selecting element 12 is 50 nsec or less.

Note that the wavelength 520 nm is a wavelength which is slightly longer than the central wavelength of the emission spectrum. Thus, at the wavelength 520 nm, some wavelength components which slow down the response speed are included in the output amplitude. Here, if it is desired to make the response speed even faster, a wavelength selecting element 12, which selects and outputs wavelengths at the shorter wavelength side of the central wavelength (i.e., wavelengths of 515 nm or less), may be used.

Fig. 4 is a diagram showing another structure of the semiconductor light-emitting element 10. A multilayer filter 13 is formed at the light-emitting surface side of the GaN type green LED 11 of the semiconductor light-emitting element 10, i.e., on the GaN end surface. The multilayer filter 13 selects and outputs only wavelengths of 520 nm or less from the green light from the GaN type green LED 11. In this way, the falling time t_{f} of the green light outputted from the multilayer filter 13 is 50 nsec or less. If it is desired to make the response speed even faster, a multilayer filter, which selects and outputs only wavelengths at the shorter wavelength side of the central wavelength (i.e., wavelengths of 515 nm or less), may be used.

Note that the configuration of the electrode of the GaN type green LED 11 is not particularly limited. However, in order for the green light to efficiently optically couple with the POF 2, the following configuration may be used for example.

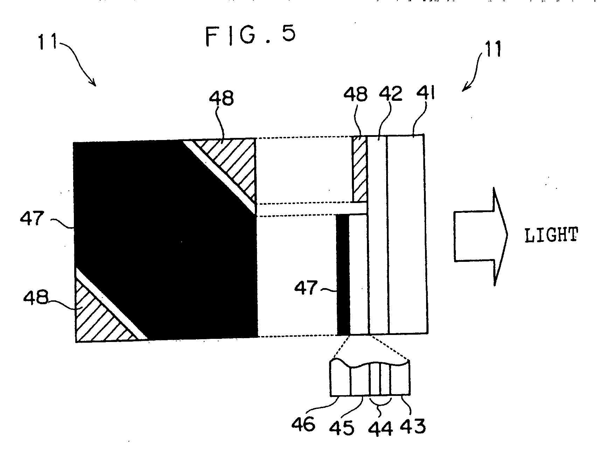

Fig. 5 is a diagram showing the structure of the GaN type green LED 11. Fig. 5 includes a plan view showing the GaN type green LED 11 as viewed from the electrode side and a cross-sectional view of the GaN type green LED 11.

An n-GaN layer 42 of a thickness of 2 µm, an n-Al_{0.1}Ga_{0.9}N layer 43 of a thickness of 0.1 µm, an InGaN/GaN multi-quantum well 44, a p-Al_{0.1}Ga_{0.9}N layer 45 of a thickness of 0.1 µm, and a p-GaN layer 46 are formed in that order on one surface of a transparent sapphire substrate 41.

A positive electrode 47 is formed on the p-GaN layer 46. Note that a portion of the n-GaN layer 42 is exposed to the exterior. A negative electrode 48 is formed at the exposed portion of the n-GaN layer 42.

The positive electrode 47 is rectangular as shown in Fig. 5. Note that the configurations of the positive electrode 47 and the negative electrode 48 are not limited to those shown in Fig. 5, and may be other configurations.

When bias current is supplied from the LED driving circuit 20 to the positive electrode 47 and the negative electrode 48, the GaN type green LED 11 which is structured in this way outputs green light corresponding to the configurations of the positive electrode 47 and the negative electrode 48. Thus, the green light outputted from the GaN type green LED 11 can be efficiently optically coupled with the POF 2.

As described above, a light-emitting element which can operate at high speed can be realized by outputting only the short wavelengths among the green light emitted at the GaN type green LED 11.

Accordingly, the optical transmission device 1 which is equipped with the semiconductor light-emitting element 10 transmits a light signal which uses only short wavelengths of the green light emitted at the GaN type green LED 11. In this way, as compared with a case in which transmission is carried out by using all of the green light including both the short wavelengths and the long wavelengths, the falling time t_{f} of the light signal can be shortened, and therefore, the response speed can be improved.

Accordingly, because the optical transmission device 1 can achieve a response speed which is equivalent to or better than that of conventional red LEDs, light signals of wavelengths at which there is low loss at the POF 2 can be outputted without resulting in high costs. Moreover, even if fluctuations in temperature arise, a decrease in the emission output and fluctuations in the wavelength can be suppressed as compared with the case of using a red LED. As a result, an optical datalink system enabling transmission of 100 m or more, which could not be achieved with conventional red LEDs, can be realized at a low cost.

Note that the present invention is not limited to the above-described embodiment, and may be structured as follows for example.

In the above embodiment, explanation is given of a case in which the wavelength selecting element 12 is provided at the semiconductor light-emitting element 10. However, the wavelength selecting element 12 may be provided at the light-receiving element 30. Namely, at the light-receiving surface side of the light-receiving element 30, an interference filter or etalon may provided as the wavelength selecting element 12, or a multilayer filter may be provided. In this way, even if such a wavelength selecting element or multilayer filter is not provided at another transmitting device, the optical transmission device 1 can improve the response speed of the transmitted light signal.

It is explicitly stated that all features disclosed in the description and/or the claims are intended to be disclosed separately and independently from each other for the purpose of original disclosure as well as for the purpose of restricting the claimed invention independent of the compositions of the features in the embodiments and/or the claims. It is explicitly stated that all value ranges or indications of groups of entities disclose every possible intermediate value or intermediate entity for the purpose of original disclosure as well as for the purpose of restricting the claimed invention.

## Claims

1. A semiconductor light-emitting element (10), comprising
a GaN type green light-emitting diode (11) emitting green light, and
a wavelength selecting element (12, 13) selecting and outputting only light of wavelengths at which a falling time of emission output of the GaN type green light-emitting diode is less than or equal to an average value.

2. The semiconductor light-emitting element of claim 1, wherein the wavelength selecting element (12, 13) selects and outputs only light of wavelengths of 520 nm or less from the green light.

3. The semiconductor light-emitting element of claim 1 or 2, wherein the wavelength selecting element (12, 13) selects and outputs only light of wavelengths of 515 nm or less from the green light.

4. The semiconductor light-emitting element of one of claims 1 to 3, wherein the wavelength selecting element (12, 13) selects and outputs only light of wavelengths less than or equal to a central wavelength of an emission spectrum of the green light.

5. The semiconductor light-emitting element of one of claims 1 to 4, wherein the wavelength selecting element (12, 13) is adhered to a light-emitting surface of the GaN type green light-emitting diode (11).

6. The semiconductor light-emitting element of one of claims 1 to 5, wherein the wavelength selecting element comprises a multilayer filter (13), and/or an interference filter (12), and/or an etalon (12).

7. An optical transmission device, comprising
a semiconductor light-emitting element (10) according to one of claims 1 to 6, and
an optical fiber (2) transmitting the green light emitted by the semiconductor light-emitting element.

8. The optical transmission device of claim 7, wherein an electrode of the semiconductor light-emitting element (10) is formed in a configuration corresponding to a cross-sectional configuration of the optical fiber (2).

9. The optical transmission device of claim 8, wherein the electrode of the semiconductor light-emitting element is formed to be circular.

10. An optical transmission device, comprising
a first semiconductor light-emitting element (10), and
a light-receiving element (30) receiving green light from a second semiconductor light-emitting element which is different from the first semiconductor light-emitting element (10),
wherein the first and/or the second semiconductor light-emitting element(s) is/are a semiconductor light-emitting element according to one of claims 1 to 6.
